# EUROPEAN PATENT APPLICATION

(11) **EP 2 800 139 A1**
(43) Date of publication of application: **05.11.2014**
(21) Application number: 13166040.9
(22) Date of filing: 30.04.2013
(51) Int. Cl.: H01L 29/778, H01L 29/872

(54) **Layer sequence for an electronic device**

(71) Applicant: Azzurro Semiconductors AG, 01237 Dresden (DE)
(72) Inventor: Murad, Saad, 01705 Freital (DE)
(74) Representative: Eisenführ Speiser

(57) **Abstract**

A layer sequence (100) for use in fabricating an electronic device, the layer sequence (100) comprising a substrate (110); a buffer layer on the substrate; a channel layer (130) made of a first group-III-nitride semiconductor material on the buffer layer structure (120); a barrier layer (150) arranged on the channel layer (130) and exhibiting a larger band-gap than the channel layer (130) on its barrier-layer side that faces the channel layer (130), allowing a formation of a two-dimensional electron gas near an interface between the channel layer (130) and the barrier layer (150); wherein the barrier layer (150) is formed by a barrier layer sequence, which comprises at least three group-III-nitride barrier-sublayers (150.1, 150.2, 150.3), of which first barrier-sublayers (105.1) having a first band-gap and second barrier-sublayers (150.2) having a second band-gap smaller than the first band gap are arranged in an alternating manner in the barrier layer sequence.

## Description

The present invention relates to a layer sequence for a high-electron-mobility transistor. The invention further relates to a wafer comprising such a layer sequence on a substrate and to a high-electron mobility transistor (HEMT) as well as to a Schottky diode.

High electron mobility transistors based on heterostructures, due to their high charge density at the heterointerface and the natural formation of a two-dimensional electron gas (2DEG) at the interface, are very promising for applications in the field of power switching and power conversion as well as in radio-frequency (RF) and high- voltage (HV) applications.

According to a first aspect of the present invention a layer sequence for use in fabricating an electronic device comprises
- a substrate;
- a buffer layer on the substrate;
- a channel layer made of a first group-III-nitride semiconductor material on the buffer layer structure;
- a barrier layer arranged on the channel layer and exhibiting a larger band-gap than the channel layer on its barrier-layer side that faces the channel layer, allowing a formation of a two-dimensional electron gas near an interface between the channel layer and the barrier layer; wherein
- the barrier layer is formed by a barrier layer sequence, which comprises at least three group-III-nitride barrier-sublayers, of which first barrier-sublayers having a first band-gap and second barrier-sublayers having a second band-gap smaller than the first band gap are arranged in an alternating manner in the barrier layer sequence.

The layer sequence achieves a reduced undesired gate current leakage in electronic devices even in combination with a high current density. This effect is achieved by the introduction of one or more additional electron barrier due to the use of a barrier layer sequence with barrier-sublayers alternating between larger and smaller band-gaps. The alternating sequence of barrier-sublayers with a larger band gap and barrier-sublayers with a smaller band-gap lowers a polarization field in the barrier layer and thus leads to a reduced gate current.

The layer sequence according to the first aspect of the invention also has the effect of a reduction of the electrical field and its peaks within the top layers of the electronic device. By reducing the peaks of electric field especially at the edges of the gate in the top layers of the device the gate leakage is reduced and the breakdown voltage is increased.

The layer sequence as such forms an intermediate product that can be fabricated by a semiconductor foundry and traded, typically in the form of a substrate wafer carrying the layer sequence, to device manufacturers. Electronic devices that can be made on the basis of the layer sequence of the first aspect of the invention are in different embodiments high-electron mobility transistors (HEMT) or Schottky diodes.

In some embodiments the first barrier-sublayers all have the same band gap, but other embodiments are also within the scope of the invention, in which different first barrier-sublayers have different band gaps. Additional embodiments have second barrier sublayers, which exhibit the same band-gap for all second barrier-sublayers, while further embodiments make use of second barrier sublayers, which have different band gaps in different ones of the second barrier-sublayers. Thus, in one embodiment of the invention the band-gap of the first barrier-sublayers is the same band-gap for every first barrier-sublayer and the band-gap of the second barrier- sublayers is the same band-gap for every second barrier-sublayer. Alternatively at least two first barrier-sublayers have respectively different band-gaps while the band-gap of the second barrier-sublayers is the same band-gap for every second barrier-sublayer. In a third alternative the band-gap of the first barrier-sublayers is the same band-gap for every first barrier-sublayer while at least two second barrier-sublayers have respectively different band-gaps. In a forth alternative at least two first barrier-sublayers have respectively different band-gaps while also at least two second barrier-sublayers have respectively different band-gaps.

In one embodiment, the band gap or band gaps of the first barrier-sublayers are larger than the band gap of the second barrier-sublayers.

In a preferred embodiment the first barrier-sublayers have lattice constants and material compositions that differ from lattice constants and material compositions of the second barrier-sublayers.

In RF HEMT devices known today undesired dispersion effects occur, which means that the actual RF output is lower than the output expected based on the direct current (DC) characteristics of the devices. In addition, in high-voltage HEMT devices after switching from a high-voltage OFF-state to a low-voltage ON-state, the ON-state resistance (R_{ON}) remains high for a certain time, which leads to conduction losses. This phenomenon is called dynamic ON-resistance. By realizing the different band-gaps of the barrier-sublayers using different compositions of group-III-nitride layer material, HEMT embodiments of the claimed layer sequence achieve a reduction of the dispersion effects and at the same time a reduction of the dynamic ON-resistance. This way, a highly efficient HV HEMT can be achieved. This advantageous effect is enhanced in embodiments where the compositions of the first and second barrier-sublayers are adjusted in a way that the strain in the barrier layer is minimized. A reduction in strain is typically accompanied by a reduction of the dislocation density. A reduced dislocation density in turn allows achieving a particularly low leakage current in HEMT embodiments, because dislocation-related leakage current paths are a major component of current leakage.

In one embodiment, the layer sequence further comprises a cap layer on the barrier layer. The channel layer, as well as the barrier layer and the cap layer are preferably undoped or exhibit low doping levels that arise from an unintentionally doping that cannot be avoided according to the present state or the art.

In a further embodiment of the layer sequence, at least one of the group-III-nitride barrier-sublayers is made of a ternary group-III nitride material. The difference in band gap can be achieved by a variation of the ratio of the mole fractions of the group-III materials, including as an option a substitution of one of the group-III materials, in particular one of Ga, Al, In or B, by another group-III material of this set.

In a preferred embodiment, the channel layer is made of GaN. Preferably, at least one of the group-III-nitride barrier-sublayers is made of AlGaN. In one embodiment AlGaN materials are used for all barrier sublayers of the barrier layer sequence. In some of these embodiments, the channel layer and the barrier form a GaN/AlGaN hetero-interface. These hetero-interfaces have the advantage of a natural formation of a two-dimensional electron gas (2DEG) at the AlGaN/GaN interface thanks to piezoelectric effects. Due to strong spontaneous polarization, the AlGaN/GaN hetero-junction produces a high charge density at the interface between AlGaN and GaN. A higher AI mole fraction in the AlGaN barrier layer results in a higher band-gap and a larger conduction band discontinuity at the AlGaN/GaN interface, which in turn results in a better carrier confinement at the interface of AlGaN and GaN. The charge density increases with increasing Al mole fraction in the barrier layer. High charge densities are desired to produce a high drain current in a transistor embodiment. A leakage current due to the strong polarization field that is also present in the AlGaN layer can be significantly suppressed by the use of the claimed layer structure. The cap layer, in particular in some of the embodiments described in this paragraph, is also made of GaN.

Preferably the difference in the AI mole fraction between first and second barrier-sublayers made of AlGaN is larger than 5 %, even more preferably larger than 10 %. Preferably the AI mole fraction is higher than 14 % in all barrier-sublayers.A preferable combination of AI mole fractions is 16 % for the second barrier-sublayers and 29 % for the first barrier-sublayers. A maximum difference in the AI mole fraction is 90 %.

In a preferred embodiment, the barrier-layer sequence comprises at least four barrier-sublayers. Preferably, one of the second barrier sublayers of this embodiment is arranged on a side of the barrier-layer facing the channel layer. This ensures that barrier-layer sequence comprises at least one attractive potential structure for electrons within its thickness extension. In this embodiment the mobility of the electrons in the channel layer is improved due to a reduced scattering at the interface.

Preferably the thicknesses of the first barrier-sublayers with a larger band gap are larger than the thicknesses of the second barrier-sublayers with a smaller band gap. This way, in HEMT devices a high drain current can be achieved by a barrier layer having a larger amount of material with the larger band-gap. This effect also benefits from the alternating sequence of materials with larger and smaller band-gaps according to the present invention. A preferred thickness of the first barrier-sublayers is in the range of 2 to 15 nm, a preferred thickness of the second barrier-sublayers is in the range of 2 to 10 nm.

The total thickness of the barrier layer can be modified either by changing the number of repetitions of the barrier layer sequence or by modifying the thicknesses of the individual barrier-sublayers. The total thickness of the barrier layer can be as high as 50 nm. Preferably the total thickness is smaller than 40 nm, even more preferably the total thickness is between 20 and 30 nm, in order to significantly suppress dispersion effects. With the use of adjusted alternating compositions of group-III-nitride layer materials in the barrier layer according to the present invention it also becomes possible to achieve a rather large overall thickness of the barrier layer. By growing a barrier layer with a larger overall thickness in comparison to a barrier layer according to the pior art that has a constant material composition, the distance between surface traps and the channel layer is increased. Thus, the effect of reduced dispersion and reduced ON-resistance in HEMT embodiments is enhanced.

In some embodiments of the layer sequence, a thin group-III-nitride spacer layer is arranged between the barrier layer and the channel layer. This spacer layer improves the electron mobility in of a 2DEG formed near the interface between the channel layer and the spacer layer. In a preferred embodiment the group-III-nitride spacer layer is made of AIN. The spacer layer preferably has a thickness of not more than 3 nm.

A wafer containing the layer sequence of the present invention can be fabricated starting from any suitable substrate for growing group-III-nitride layers. However, care has to be taken to provide a suitable high resistivity buffer-layer structure with a breakdown electric field strength of typically 1-3MV/cm or even higher. At the same time, the buffer layer structure should be configured to compensate strain in the layer structure that may arise from differences in lattice constants and coefficients of thermal expansion, especially between the substrate and the group-III-nitride layers grown on it. By proper strain management, as is well known in the art, it is possible to avoid cracks and wafer bow and to keep the concentration of defects in the crystalline structure to an acceptably low value. Maximum sheet defect densities in the layer sequence achieved with a suitable buffer-layer structure preferably in the range between 5x10⁷ and 4x10⁹ cm⁻².

A preferred substrate material is silicon because it can be provided in large diameters with high purity and at low cost. Furthermore, the use of a silicon wafer as the substrate allows fabricating electronic devices according to embodiments of the present invention together with other silicon-based semiconductor devices on a single wafer. Thus, the use of a silicon wafer even allows an integration of the fabrication of this transistor into a known highly-developed industrial process for the fabrication of an integrated circuit, such as a MOS, NMOS, PMOS, CMOS or BiCMOS process.

As has been pointed out before, the layer sequence of the present invention or one of its embodiments disclosed herein is incorporated in advantageous embodiments forming a high electron mobility transistor (HEMT) according to the present invention. Advantages of such HEMT embodiments have been described in the context of the corresponding embodiments of the layer structure.

The layer sequence of the present invention or one of its embodiments can also be incorporated in a respective embodiment of a Schottky diode.

In the following, further examples of the layer sequence of the present invention and of the high electron mobility transistor that is based on this layer sequence will be described.
- Fig. 1: shows a layer sequence for a HEMT or Schottky diode according to a first embodiment;
- Fig. 2: shows a layer sequence for a HEMT or Schottky diode according to a second embodiment;
- Fig. 3: shows a conduction-band profile in a layer sequence for a HEMT according the prior art;
- Fig. 4: shows a conduction-band profile in an embodiment of a layer sequence for a HEMT according the invention shown in Table 2;
- Fig. 5: shows a conduction-band profile in a layer sequence for a HEMT according the invention shown in Table 3;

- Fig. 6a: shows an electrical field distribution in a HEMT according to the prior art using the layer sequence of Table 1,
- Fig. 6b: shows the electrical field along the line A-A of Fig. 6a
- Fig. 7a: shows an electrical field distribution in a HEMT using the layer sequence according to Table 2;
- Fig. 7b: shows the electrical field along the line A-A of Fig. 7a;
- Fig. 7c: shows the electrical field along the line B-B of Fig. 7a;
- Fig. 8a: shows the electrical field in a HEMT using the layer sequence according to Table 4 under the drain side edge of the T-crossbar of the gate;
- Fig. 8b: shows the electrical field under the drain side edge of the gate.

The illustrations in the following Figures are schematic, in particular in that layer thicknesses are not drawn to scale. Furthermore, only those layers are shown, which convey the basic design, the design options and the advantages of the layer sequence of the respective embodiment. For instance, details of a buffer-layer sequence are not shown in the Figures. It is further pointed out that the embodiments are of exemplary nature and are not presented to imply that all layers shown in a respective Figure are in fact necessary to implement a layer sequence according to the present invention.

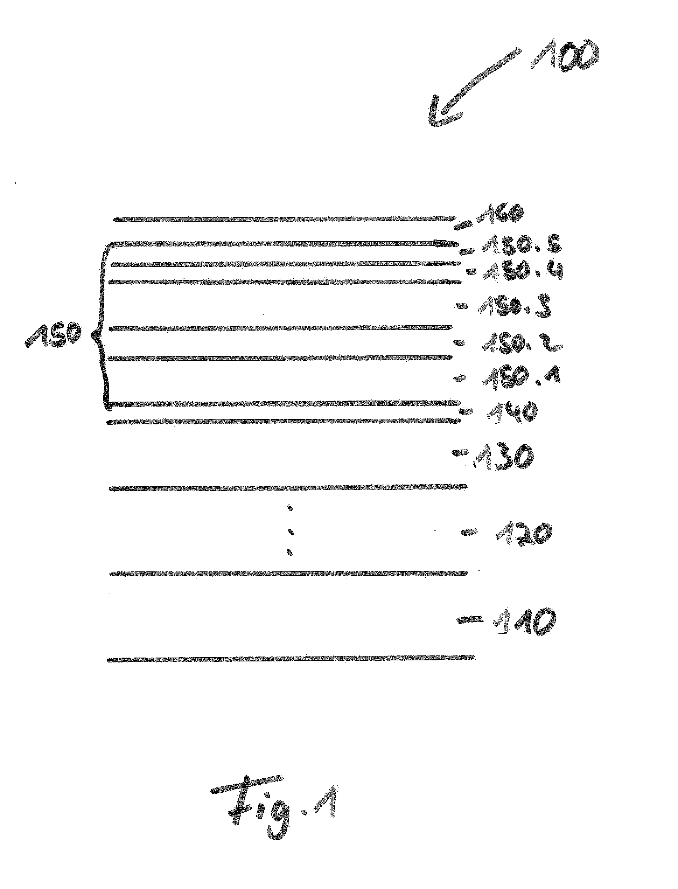

Fig. 1 shows a layer sequence according to a first embodiment of the invention. The layer sequence 100 is deposited on a substrate 110, which for instance is a silicon wafer. Other known substrate materials suitable for the deposition of group-III-nitride materials may be used. However, silicon is preferred due to the economic and technological advantages involved in using industry-standard, large-scale wafers.

On the silicon wafer 110, a nucleation and buffer layer structure 120 is grown. The nucleation and buffer layer structure 120 typically has a sublayer structure in order to enable the growth of a crack-free, low-defect-density layer structure with a virtually vanishing wafer bow. In particular, the nucleation and buffer layer structure serves for adequately compensating stress in the layer structure, which is caused during the fabrication process by differences in lattice constants and coefficients of thermal expansion of the substrate and of the group-III-nitride materials grown on the substrate. Suitable nucleation and buffer layer structures are known in the art.

The layer sequence 100 of the present embodiment is deposited on the nucleation and buffer layer structure 120 and comprises, according to the applied order of deposition, a channel layer 130, a spacer layer 140, a barrier layer 150 comprising three first barrier-sublayers 150.1, 150.3 and 150.5, two second barrier sublayers 150.2 and 150.4 and a cap layer 160.

The channel layer 130 is made of GaN. In the language of the claims, it forms an example of the second group-III-nitride material. The cap layer 160 is also made of GaN in this embodiment (second group-III-nitride material). The spacer layer 140 is made of AIN.

The thickness of the channel layer is typically between 500 and 2000 nm, for instance 1500 nm. The spacer layer 140 is a thin layer with a typical thickness between 1 and 2 nm. The thickness of the cap layer 160 is typically between 2 and 6 nm, for instance 2 nm.

The barrier layer 150 in this embodiment comprises five barrier-sublayers 150.1 to 150.5. The barrier-sublayers are all made of group-III-nitrides. More specifically, the barrier-sublayers in this embodiment are of different compositions of AlGaN. As described before, there is considerable freedom in the specific selection of the AI and Ga mole fractions of the barrier-sublayers 150.1 to 150.5. In the present embodiment, the first barrier sublayers 150.1, 150.3 and 150.5 are made of AlₓGa₁₋ₓN with an aluminium mole fraction x of 29 %, while the second barrier sublayers 150.2 and 150.4 are made of AlₓGa₁₋ₓN with an aluminium mole fraction x of 16 %. This material combination has proven to be very advantageous.

Thus, the channel layer is made of a first group-III-nitride material that has a band-gap energy that is lower than the band-gap energy of the first barrier-sublayer 150.1 on the side of the barrier layer 150 facing the channel layer. At the same time the band-gap energies of the barrier-sublayers 150.1 to 150.5 alternate. The first barrier sublayers 150.1, 150.3 and 150.5 have larger band-gaps than the second barrier sublayers 150.2 and 150.4, thus two additional potential valleys are created in the barrier layer. This way, a potential structure is formed in the conduction band of the barrier layer, which is attractive for electrons.

The thicknesses of the first barrier-sublayers are larger than the thicknesses of the second barrier-sublayers. In the shown embodiment the first barrier-sublayer 150.1 has a thickness of 12 nm, the additional first barrier-sublayer 150.3 has a thickness of 8 nm and an additional first barrier-sublayer 150.5 has a thickness of 2 nm. The second barrier-sublayer 150.2 has a thickness of 4 nm, while the additional second barrier-sublayer 150.4 has a thickness of 2 nm.

In another embodiment (not shown) the same layer thickness is used for the two types of barrier-sublayers with their different band-gaps. However, in the shown embodiment the strain in the barrier layer is reduced compared with a barrier layer having a constant composition of AlGaN that is deposited between a GaN channel layer and a GaN cap layer. This is due to the introduction of second barrier-sublayers having a lower amount of AI and thus a larger lattice constant between the first barrier-sublayers, which have a higher AI content and thus a smaller lattice constant. At the same time, the first barrier-sublayers having a larger band-gap contribute to a high charge density at the hetero-interface between the channel layer and the barrier layer and to a high electron mobility. Thus the described layer sequence is particularly suitable for application in a highly efficient HEMT with low dispersion.

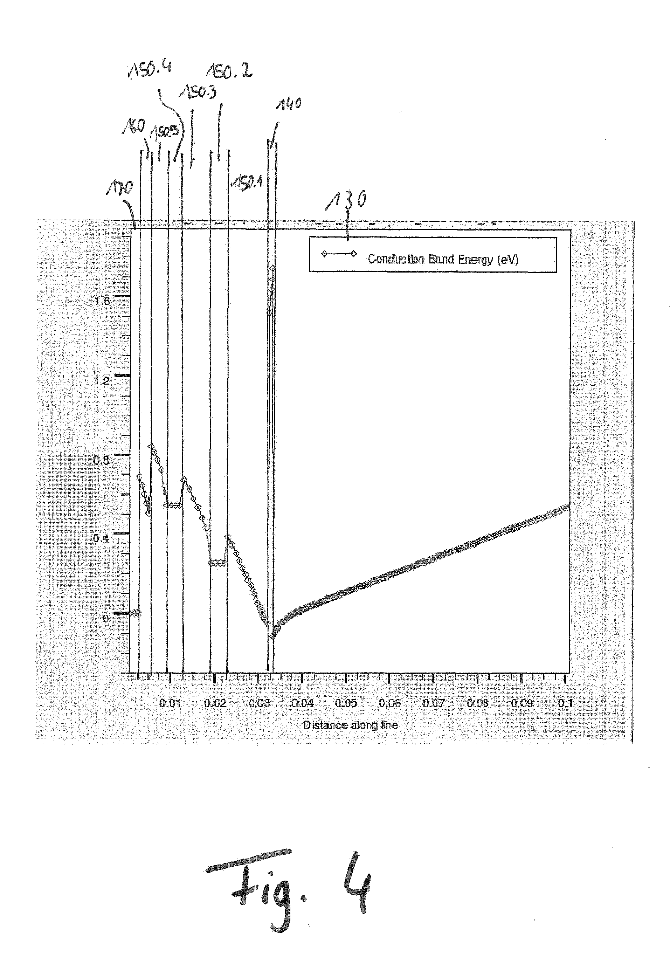

Additional advantages due to the band-gap profile of the layer sequence of this embodiment are described later in the context of Fig. 4.

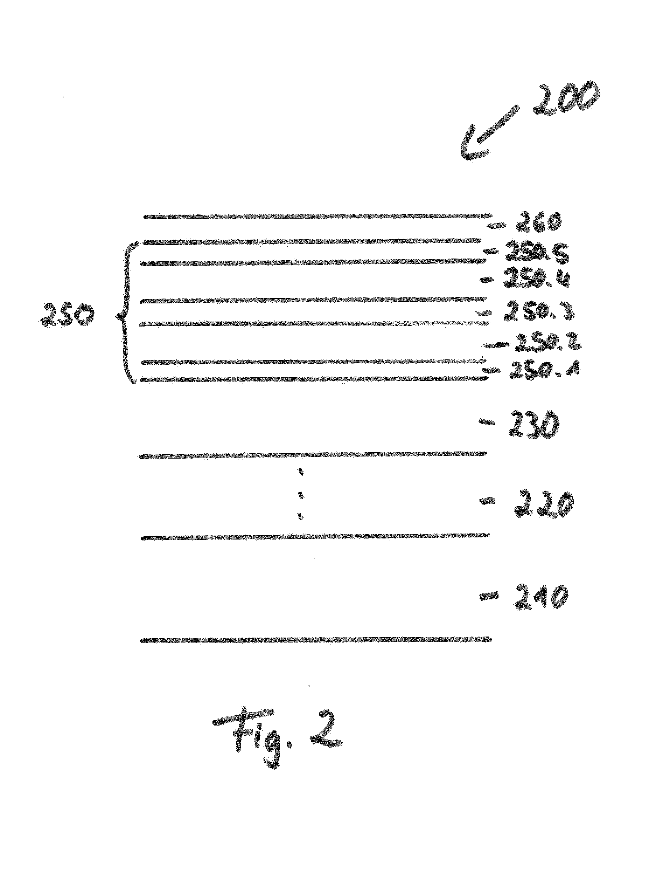

Fig. 2 shows a schematic illustration of a layer sequence 200 according to a second embodiment. The structure of the layer sequence 200 is similar to that of the layer sequence 100 of Fig. 1 in that it has a substrate 210, a buffer layer structure 220, a channel layer 230 and a cap layer 260. It differs from the embodiment of Fig. 1 in that no spacer layer is present, and in some differences of the barrier layer 250, which will be described in the following. In the present embodiment, a second barrier-sublayer 250.1 grown directly on the channel layer 230 is made of AlₓGa₁₋ₓN with an aluminium mole fraction x of 16 %. The second barrier-sublayer 250.1 has a thickness of 2 nm. Due a the rather low AI mole fraction of the second barrier-sublayer 250.1, the lattice mismatch of the barrier layer to the channel layer 230, which in this embodiment also made of GaN, is reduced in comparison with the embodiment of Fig. 1. Thus, the strain and the dislocation density in the barrier layer 250 are reduced. On the second barrier-sublayer 250.1, a first barrier-sublayer 250.2 made of AlₓGa₁₋ₓN with an aluminium mole fraction x of 29 % is grown. The first barrier-sublayer 250.2 has a thickness of 12 nm. Three additional barrier-sublayers 250.3 to 250.5 follow in the layer sequence: a 3 nm thick second barrier-sublayer 250.3 made of AlₓGa₁₋ₓN with an aluminium mole fraction x of 16 %, an 8 nm thick first barrier-sublayer 250.4 made of AlₓGa₁₋ₓN with an aluminium mole fraction x of 29 %, and a 3 nm thick second barrier-sublayer 250.5 made of AlₓGa₁₋ₓN with an aluminum mole fraction x of 16 %.With respect to the properties and parameters of the other layers of the layer sequence 200, reference is made to the description of the embodiment of Fig. 1.

As already described, the alternation of the barrier-sublayers with different compositions according to the present embodiment enhances the strain and dislocation density in the barrier layer and improves the dispersion behaviour of a HEMT based on the layer structure.

In another embodiment of the invention the thicknesses of the barrier sublayers are the same as shown in Fig. 2, but the barrier-sublayers have different AI mole fractions, for example: 14 % in second barrier-sublayer 250.1, 25 % in first barrier-sublayer 250.2, 16 % in second barrier-sublayer 250.3 and in second barrier-sublayer 250.5 and 29 % in first barrier-sublayer 250.4. Such a combination of AI mole fractions further improves the strain management in the barrier layer.

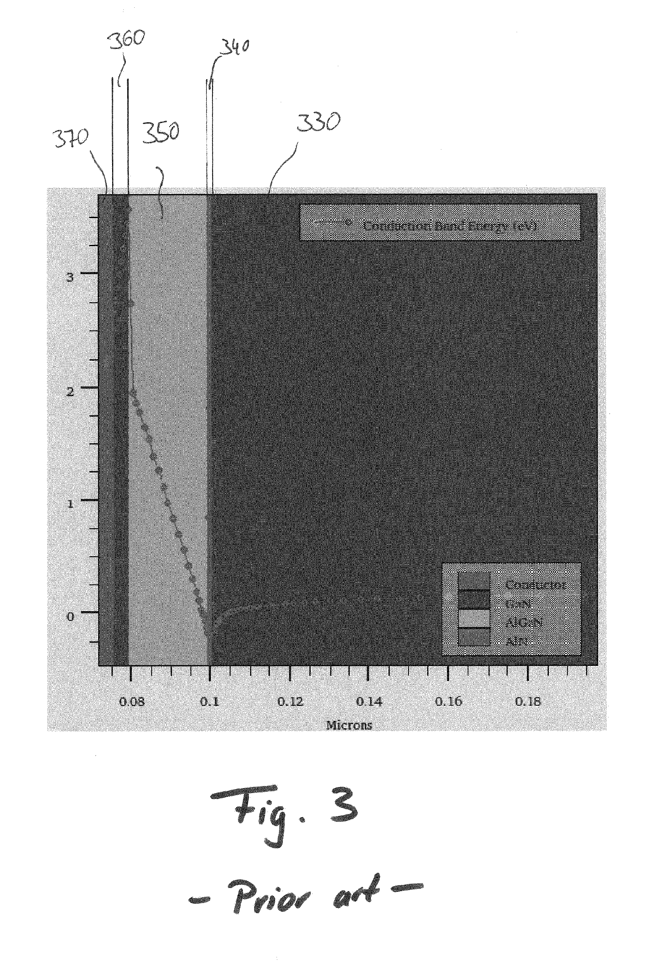

Fig. 3 shows a conduction-band profile in a layer sequence for a HEMT transistor according to the prior art. The conduction-band profile shows the energy level of the lower conduction-band edge in units of eV on a linear scale along the vertical axis (ordinate), plotted as a function of a position in a depth direction shown in linear units along the horizontal axis (abscissa). The uppermost layer of the prior-art layer sequence is on the left side adjacent to the ordinate. The prior-art layer sequence comprises the following layers:

**Table 1: Prior art layer structure, cf. Fig. 3**

| **Layer** | **Composition** | **Thickness** |
|---|---|---|
| 370 | Conductor | |
| 360 | GaN | ∼ 4 nm |
| 350 | AlGaN, x = 23% | ~ 20 nm |
| 340 | AlN | < 1 nm |
| 330 | GaN | ~ 1500 nm |

As can be seen, the resulting lower conduction-band profile has a minimum at the interface between the GaN channel layer 330 and the AIN spacer layer 340, which has an energy that is lower than the Fermi energy (at 0 eV in Fig. 3). This minimum leads to the spontaneous formation of a 2DEG even without applying an operation voltage to the layer structure. The barrier layer 350 shows a continuous decrease in the conduction band energy from the contact side of the barrier to the channel side of the barrier. Thus the barrier layer 350 is only a smooth barrier for electrons travelling from the contact to the channel.

Fig. 4 shows an illustration of a conduction-band profile in an embodiment of a high electron mobility transistor 100 according to the present invention and shown in Table 2. This embodiment is a variant of the embodiment described in Fig. 1 The conduction-band profile shows the energy level of the lower conduction-band edge in units of eV on a linear scale along the vertical axis (ordinate), plotted as a function of a position in a depth direction shown in linear units along the horizontal axis (abscissa)The conduction-band profile of Fig. 4 is taken under a metallic gate contact 170 on top of the cap layer 160 (not shown in Tab. 2).

**Table 2: layer structure underlying Fig. 4**

| **Layer** | **Composition** | **Thickness** |
|---|---|---|
| 160 | GaN | 2 nm |
| 150.5 | AlGaN, x = 29% | 2nm |
| 150.4 | AlGaN, x = 16% | 2nm |
| 150.3 | AlGaN, x = 29% | 8nm |
| 150.2 | AlGaN, x = 16% | 4nm |
| 150.1 | AlGaN, x = 29% | 12nm |
| 140 | AlN | 1-2nm |
| 130 | GaN | ∼ 1500 nm |

As can be seen, the resulting lower conduction-band structure profile has two minima at the respective positions of the second barrier-sublayers 150.2 and 150.4. These minima form attractive potentials for electrons and correspondingly create two additional barriers for electrons traveling in a direction from the cap layer to the channel layer. The layer sequence is therefore suitable for a HEMT with reduced current leakage.

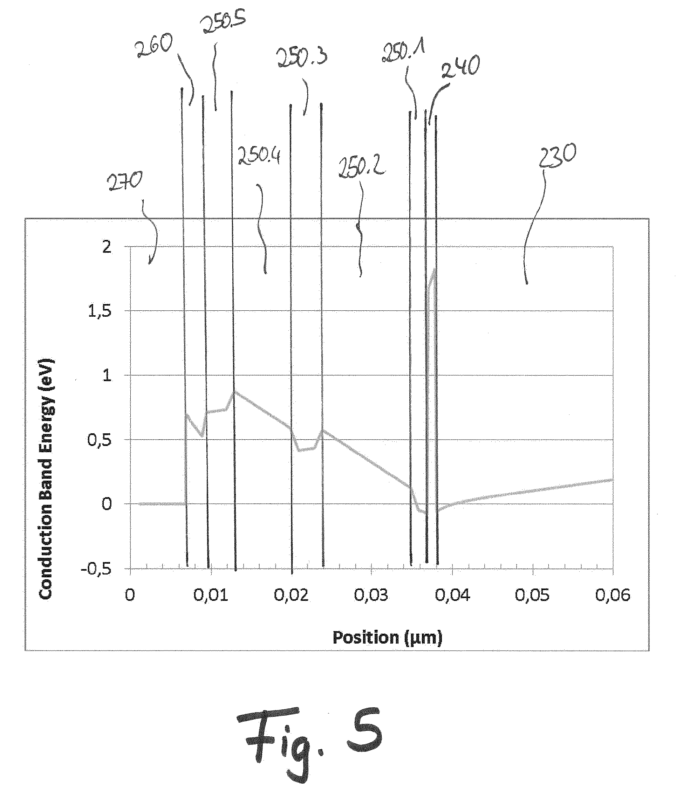

Fig. 5 is an illustration of a conduction-band profile in an embodiment of a high electron mobility transistor 200 according to an embodiment of the present invention and shown in Table 3. This embodiment is a variant of the embodiment described in Fig. 2. However, an additional AIN spacer layer is present here. The conduction-band profile shows the energy level of the lower conduction-band edge in units of eV on a linear scale along the vertical axis (ordinate), plotted as a function of a position in a depth direction shown in linear units along the horizontal axis (abscissa) The conduction-band profile of Fig. 5 is taken under a metallic gate contact 270 on top of the cap layer 260 (not shown in Tab. 3).

**Table 3: layer structure underlying Fig. 5**

| **Layer** | **Composition** | **Thickness** |
|---|---|---|
| 260 | GaN | 2 nm |
| 250.5 | AlGaN, x = 16% | 3nm |
| 250.4 | AlGaN, x = 29% | 8nm |
| 250.3 | AlGaN, x = 16% | 3nm |
| 250.2 | AlGaN, x = 29% | 12nm |
| 250.1 | AlGaN, x = 16% | 2nm |
| 240 | AlN | 1-2 nm |
| 230 | GaN | ~ 1500 nm |

As can be seen, the resulting lower conduction-band structure profile has three minima in the second barrier-sublayers 250.1, 250.3 and 250.5. These minima function as attractive potentials for electron,s as described earlier.

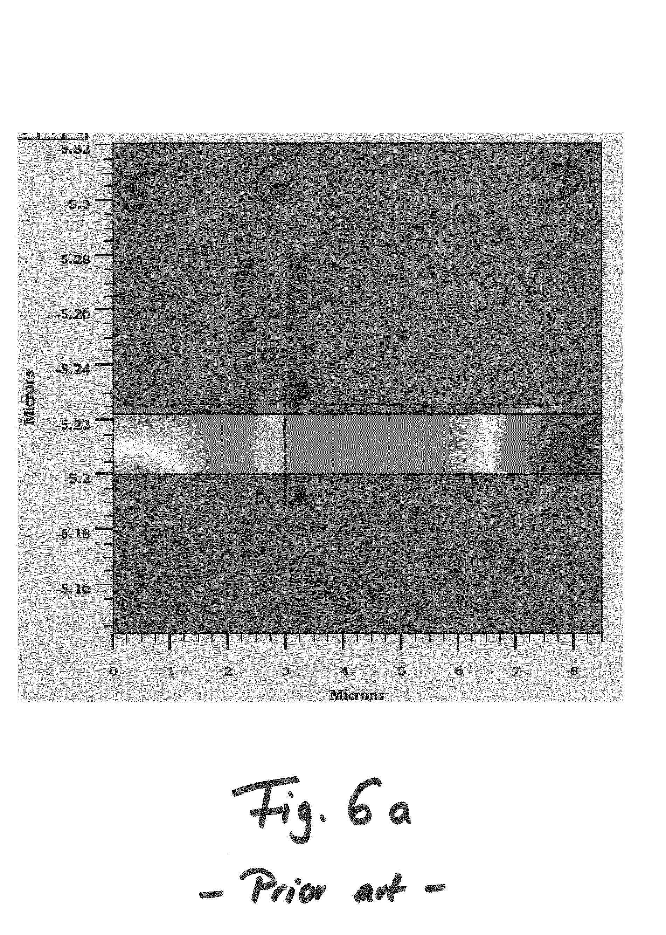

Fig. 6a shows the electrical field distribution in a prior-art HEMT using the layer structure shown in Table 1 at a drain voltage of 50 V and -3V on the gate. A drain D is shown on the right side of a gate G, and a source S is positioned on the left. The area under the gate G shows a relatively high electrical field amplitude.

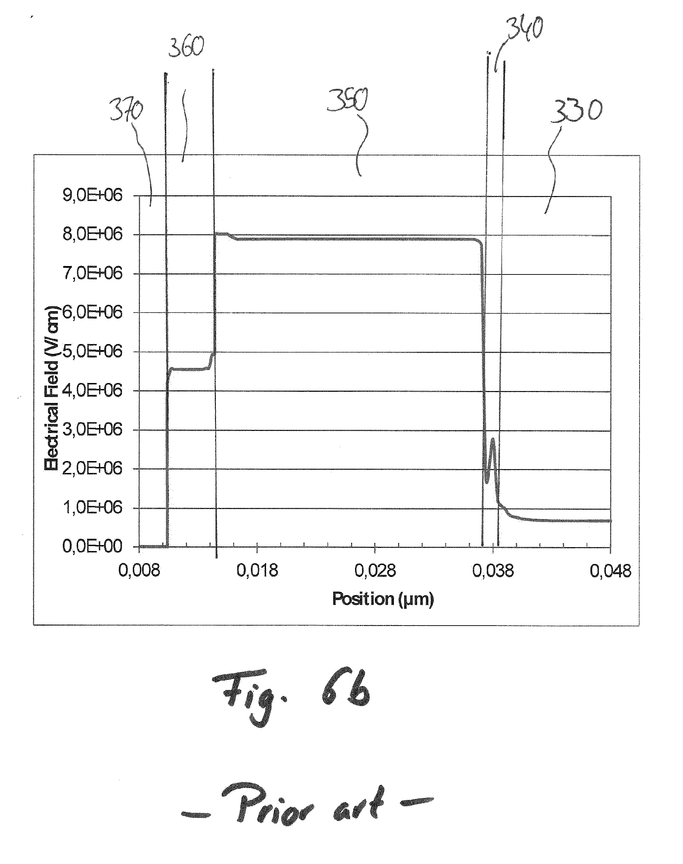

Fig. 6b shows the electric field along line A-A under the drain side edge of the gate G in the prior-art HEMT using the layer structure shown in Table 1 at the same drain voltage of 50 V, and -3V applied to the gate. The electrical field in the AlGaN layer is rather high with 8 x 10⁶ V/cm. This is unfavorable as it leads to stronger gate leakage. The electrical field in the conductor 370 is zero, and in the GaN cap layer 360 it increases up to 4.5 x 10⁶ V/cm. The highest level is in the single AlGaN barrier layer 350. In the AIN layer 340 a small peak of 2.5 x 10⁶ V/cm can be seen, while in the channel layer the electrical field drops to 7 x 10⁵ V/cm.

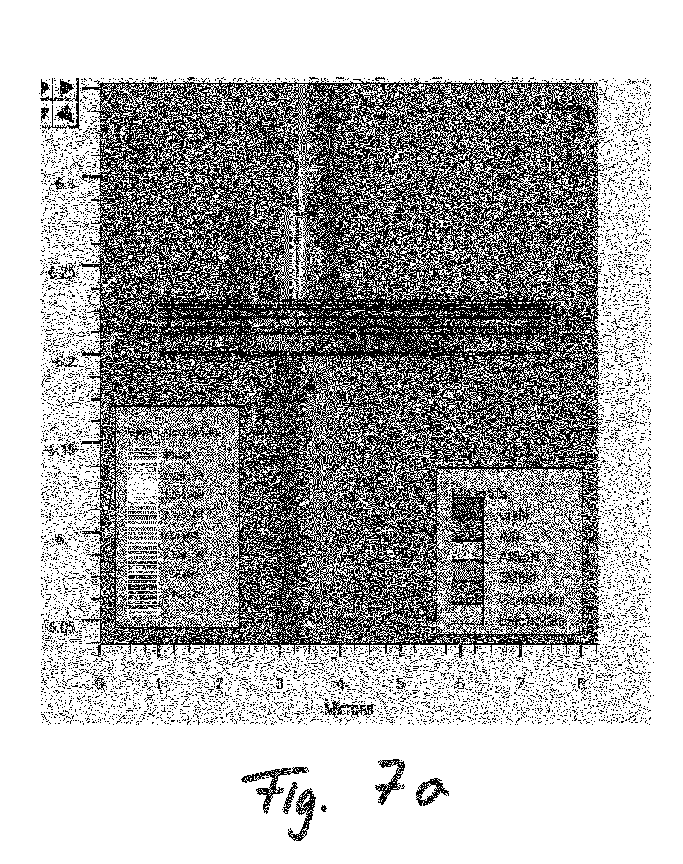

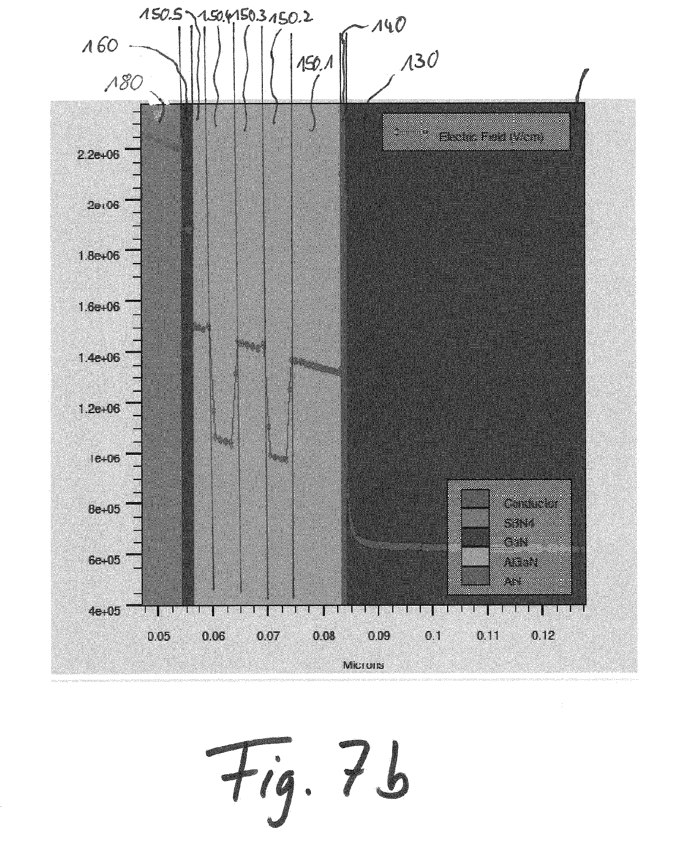

Fig. 7a shows an electrical field distribution in a HEMT using the layer sequence according to the invention as shown in Table 2 at a drain voltage of 50 V, and -4V applied to the gate. The drain D is shown on the right side of the gate G, and the source S is positioned on the left. The electrical field in the barrier layers is significantly lower than in the prior art HEMT shown in Fig. 6a. Additionally the peaks of the electrical field are laterally shifted towards the drain side of the gate. This becomes even clearer in Fig. 7b, which shows the electrical field under the drain side edge of the (horizontal) crossbar (line A-A) of the the T-shaped gate G. The peak in the electrical field under the drain side edge of the T-crossbar of the gate G is 1.5 x 10⁶ V/cm. On top of the GaN cap layer 160 an insulation layer 180 of Si₃N₄ is shown. In this insulation layer the electrical field is 2.2 x 10⁶ V/cm. I n the cap layer 160, the field drops to 1.9 x 10⁶ V/cm. In the first barrier-sublayers 150.5, 150.3 and 150.1, the electrical field shows a slight drop starting from 1.5 x 10⁶ V/cm at the side towards the cap layer 160 to 1.35 x 10⁶ V/cm at the side towards the AIN layer 140. In between, in the second barrier-sublayers 150.4 and 150.2 the electrical field is significantly lower than in the first barrier-sublayers and shows also a slight drop from 1.05 x 10⁶ V/cm to 1.0 x 10⁶ V/cm.

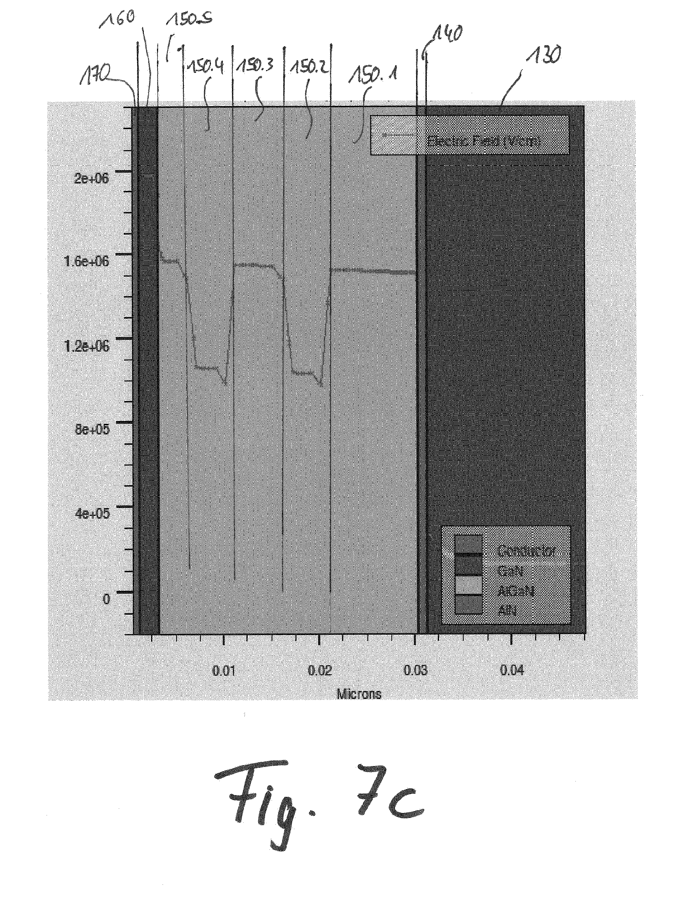

Fig. 7c shows the electrical field for the same layer structure as in Fig. 7b, but under the drain side edge of the gate (line B-B). Starting with an electrical field of 2.0 x 10⁶ V/cm in the cap layer 160, it drops to 1.6 x 10⁶ V/cm in the first barrier-sublayers 150.5, 150.3 and 150.1, where it stays nearly constant within these first barrier-sublayers. In the second barrier-sublayers 150.4 and 150.2 once more the minima in the electrical field can be seen, here at 1.05 x 10⁶ V/cm.

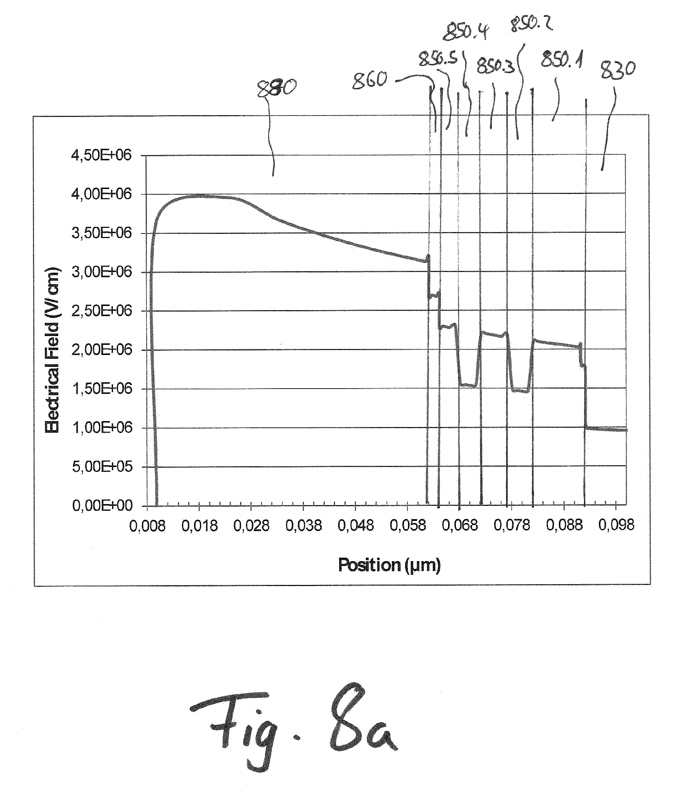

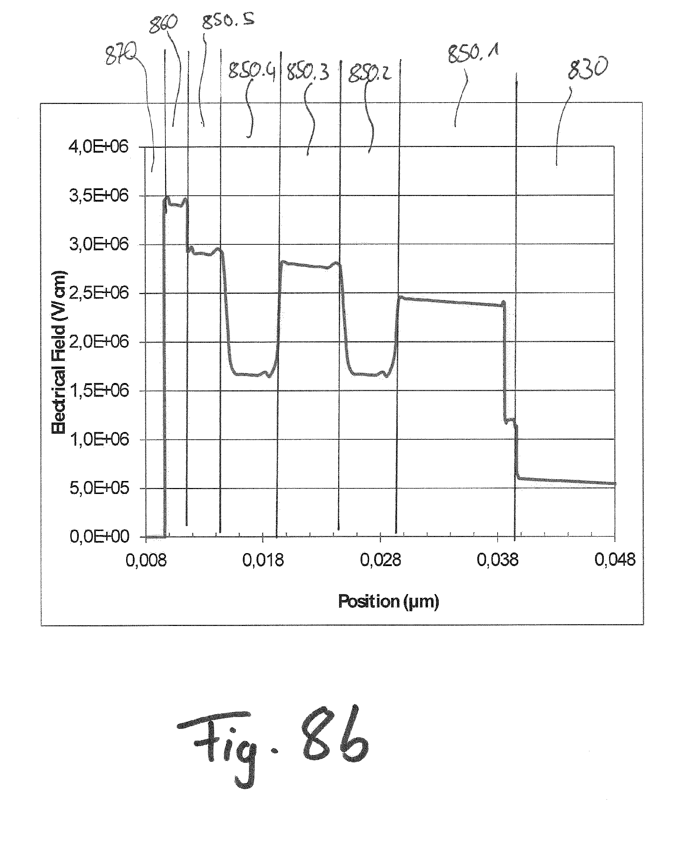

Fig. 8a and Fig. 8b show the electrical field in a HEMT using a layer sequence according to an embodiment of the invention, which is similar to that underlying Fig. 7b and 7c. The exact layer sequence is shown in Table 4 below. It differs from the layer sequence in Table 2 only by the absence of the AIN spacer layer. The electrical field is shown at a drain voltage of 50 V, and -4V applied on the gate. Fig. 8a shows the electrical field under the drain'-side edge of the T-crossbar. Without the AIN layer, the peak in the electrical field under the drain-side edge of the T-crossbar (line A-A) in the barrier layer is 2.25 x 10⁶ V/cm, which is significantly lower than in the prior-art structure and thus favorable for lower gate leakage. The electrical field in the cap layer 860 is 2.7 x 10⁶ V/cm, it drops to 2.25 x 10⁶ V/cm in the first barrier-sublayer 850.5 and, as already seen in Fig. 7b drops slightly across the other first barrier-sublayers 850.3 and 850.1. to 2.0 x 10⁶ V/cm. In the second barrier sublayers 850.4 and 850.2 minima in the electrical field of nearly 1.5 x 10⁶ V/cm show up.

Fig. 8b shows the electrical field under the drain side edge of the gate (line B-B). In the cap layer 860 the electrical field is 3.5 x 10⁶ V/cm. It drops to 2.9 x 10⁶ V/cm in the first barrier-sublayer 850.5. A further dropping across the other first barrier-sublayers 850.3 and 850.1 can be seen. The minima in the electrical field, here at 1.6 x 10⁶ V/cm show up in the second barrier layers 850.2 and 850.4. As can be seen also without the use of AIN intermediate layer the electrical field can be significantly lowered by using alternating material compositions of AlGaN barrier-sublayers with different band-gaps.

**Table 4: layer structure according the invention, cf. Fig. 8**

| **Layer** | **Composition** | **Thickness** |
|---|---|---|
| 860 | GaN | 2 nm |
| 850.5 | AlGaN, x = 29% | 2nm |
| 850.4 | AlGaN, x = 16% | 2nm |
| 850.3 | AlGaN, x = 29% | 8nm |
| 850.2 | AlGaN, x = 16% | 4nm |
| 850.1 | AlGaN, x = 29% | 12nm |
| 830 | GaN | ~ 1500 nm |

## Claims

1. A layer sequence for use in fabricating an electronic device, the layer sequence comprising
- a substrate;
- a buffer layer on the substrate;
- a channel layer made of a first group-III-nitride semiconductor material on the buffer layer structure;
- a barrier layer arranged on the channel layer and exhibiting a larger band-gap than the channel layer on its barrier-layer side that faces the channel layer, allowing a formation of a two-dimensional electron gas near an interface between the channel layer and the barrier layer; wherein
- the barrier layer is formed by a barrier layer sequence, which comprises at least three group-III-nitride barrier-sublayers, of which first barrier-sublayers having a first band-gap and second barrier-sublayers having a second band-gap smaller than the first band gap are arranged in an alternating manner in the barrier layer sequence.

2. The layer sequence according to claim 1, wherein the first barrier-sublayers have different lattice constants and different material compositions than the second barrier-sublayers.

3. The layer sequence of claim 1 or 2, further comprising a cap layer on the barrier layer.

4. The layer sequence of one of the preceding claims, wherein at least one of the group-III-nitride barrier-sublayers is made of a ternary group-III-nitride material.

5. The layer sequence of one of the preceding claims, wherein at least one of the group-III-nitride barrier-sublayers is made of AlGaN.

6. The layer sequence of one of the preceding claims, wherein the channel layer and the cap layer are made of GaN.

7. The layer sequence of one of the preceding claims, wherein on a barrier-layer side facing the channel layer one of the second barrier-sublayers is arranged and wherein the barrier layer sequence comprises at least four barrier-sublayers.

8. The layer sequence of one of the preceding claims, wherein the thicknesses of the first barrier-sublayers are larger than the thicknesses of the second barrier-sublayers.

9. The layer sequence of one of the preceding claims, wherein the thickness of the barrier layer is in a range between 20 and 30 nm.

10. The layer sequence of one of the previous claims, wherein between the barrier layer and the channel layer an additional group-III-nitride spacer layer is present.

11. The layer sequence of claim 10, wherein the group-III-nitride spacer layer consists of AIN.

12. A wafer, comprising a layer sequence according to one of the previous claims on a substrate.

13. A high-electron-mobility transistor, comprising a layer sequence according to one of the claims 1 to 11, and source, drain and gate contacts formed on the layer structure.

14. A Schottky diode comprising a layer sequence according to one of the claims 1 to 11, and a metal layer formed on the layer structure forming a Schottky junction therewith.
